# EUROPEAN PATENT APPLICATION

(11) **EP 4 611 521 A1**
(43) Date of publication of application: **03.09.2025**
(21) Application number: 24160614.4
(22) Date of filing: 29.02.2024
(51) Int. Cl.: H10N 60/84, H10N 60/85, G01J 1/44

(54) **ACTIVE ELEMENT FOR SINGLE PHOTON DETECTION, SINGLE PHOTON DETECTOR AND METHOD OF MANUFACTURING AN ACTIVE ELEMENT FOR SINGLE PHOTON DETECTION**

(71) Applicant: Ludwig-Maximilians-Universität München, 80539 München (DE)
(72) Inventor: Di Battista, Giorgio, 80799 München (DE); Efetov, Dmitri K., 80799 München (DE)
(74) Representative: Tautz & Schuhmacher

(57) **Abstract**

Provided is an active element (10) for single photon detection, the active element (10) comprising a graphene layer stack (12) comprising at least two graphene layers (14) stacked on top of each other with a global twist angle (*θ_{global}*) forming an active area (16), wherein the global twist angle is in a range from 0,90° to 1,25°. The at least two graphene layers (14) are stacked on top of each other such that a standard deviation of local deviations (*θ*₁,..., *θ_{N}*) from the global twist angle (*θ_{global}*) in the active area (16) is 0,04° or less.

## Description

Provided are an active element for single photon detection, a single photon detector, a method of detecting a single photon, and a method of manufacturing an active element for single photon detection. The disclosure is, thus, related to devices and methods for single photon detection.

The sensitive detection of single light quanta (photons) is a crucial technology with applications in communication, radio astronomy, quantum networks, and spectroscopy. Some conventional superconducting photodetectors rely on the photon-induced breaking of Cooper pairs. In superconducting materials, the electrical current flows without resistance. When a photon is absorbed, it can generate quasiparticles above the superconducting gap, introducing a change in impedance. Some state-of-the-art single photon detectors (also referred to by the abbreviation: SPD) rely on heat induced breaking of the superconducting state in nanostructured superconductors (SCs).

Two-dimensional superconductors offer a unique approach for SPD from the material perspective. The confinement in the reduced two-dimensions could suppress the heat capacity and electron-phonon coupling, leading to a larger temperature rise among the electrons upon the absorption of a single photon. More intriguingly, a recent discovery revealed that the flat electronic band structure produced by stacking two layers of graphene by a twist angle in a predetermined range, also referred to as a 'magic' angle, with respect to each other leads to a novel superconducting phase. This discovery has expanded into an entire family of graphene-based superconductors, prompting exploration of their potential application in SPD.

To this date, the state of the art SPD technology in the visible to near infrared optical range is represented by superconducting transition-edge sensors (TES) and superconducting nanowire single photon detectors (SNSPDs).

Transition-edge sensor (TES) detectors involve a temperature increase due to absorbed photon energy, locally interrupting the superconducting state and causing a sensitive change in electrical resistance measured with superconducting quantum interference device (SQUID) probes. TES detectors, based on MATBG and other graphene-based superconductors, are known in prior art [1,2]. The other alternative is represented by superconducting nanowires single-photon detectors (SNSPDs), consisting of nanostructured superconducting strips cooled down well below their critical temperature and operating at a bias current slightly smaller than the critical current [3]. Photon absorption generates quasiparticles which are confined in the small width of the strip, rapidly destroying superconductivity and generating a short-lived resistive region, resulting in a measurable voltage signal.

The above cited prior art documents are identified in the following:
1. Seifert P.et al. Magic-angle bilayer graphene nano-calorimeters - towards broadband, energy-resolving single photon detection. Nano Lett. 20, 3459-3464 (2020).
2. US 2021/0140833 A1
3. Morozov, D. V. et al. Superconducting photon detectors. Contemporary Physics 62, 69-91 (2021).

Despite advancements and commercialization in SPD for visible and near-infrared wavelengths, there remains a technological gap in the mid-infrared and terahertz range due to the inherently low energy of photons in these spectral regions.

The technical problem may, thus, relate to providing an active element for single photon detection, a single photon detector, a method of detecting a single photon and a method for manufacturing an active element for single photon detection enriching the state of the art. Optionally, the technical problem may relate to providing an active element for single photon detection, a single photon detector, a method of detecting a single photon and a method for manufacturing an active element for single photon detection enabling or improving single photon detection in particular in the infrared spectral range and optionally in the Terahertz spectral range and/or at an enhanced sensitivity.

This problem is solved by an active element for single photon detection, a single photon detector, a method of detecting a single photon and a method for manufacturing an active element for single photon detection having the features of the respective independent claim. Optional embodiments are provided in the dependent claims and in the description.

An active element for single photon detection is provided. The active element comprises a graphene layer stack comprising at least two graphene layers stacked on top of each other with a global twist angle forming an active area, wherein the global twist angle is in a range from 0,90° to 1,25°. The at least two graphene layers are stacked on top of each other such that a standard deviation of local deviations from the global twist angle in the active area is 0,04° or less.

In another aspect, a single photon detector is provided. The single photon detector comprises at least one active element according to the disclosure.

In yet another aspect, a method of detecting a single photon is provided. The method comprises providing a single photon detector according to the disclosure. The method further comprises bringing the active area of the single photon detector into a superconductive state, and applying a gate voltage to the active area such that an electrostatic doping level of the active area is in a range between half-filling and three-quarter filling of a Moiré unit cell, -3 < v < -2, and optionally to v=-2.45. Moreover, the method comprises applying a bias voltage across the active area (16) within a defined range from 95% to 100% of a switching voltage (*V_{c}*), wherein the switching voltage (*V_{c}*) is a voltage, at which, when applied across the active area, the active area transitions from the superconductive state to a normal conductive state. The method further comprises measuring a probe voltage at the active area, and determining an event in which the measured probe voltage exhibits a voltage change of 0,3 mV or more and/or a change in resistivity of the active area of 5 kΩ or more corresponding to the entire active area switching from the superconductive state into the normal conductive state as the absorption of a photon in the active area.

In yet another aspect, a method of manufacturing an active element for single photon detection is provided. The method comprises forming a graphene layer stack including stacking at least two graphene layers of the graphene layer stack on top of each other with a global twist angle, wherein the global twist angle is in a range from 0,90° to 1,25°. The method further comprises selecting an area of the graphene layer stack having a higher homogeneity than other areas of the graphene layer stack as an active area for the single photon detection, wherein the higher homogeneity corresponds to the at least two graphene layers of the graphene layer stack being stacked on top of each other such that a standard deviation of local deviations from the global twist angle in the active area is 0,04° or less.

An active element may be an element usable in a single photon detector, in which the actual physical process of photon absorption occurs that is required for detecting the photon. The active element may provide a signal indicating the absorption of a single photon. The active element may be used in combination with other elements for receiving, reading out, enhancing, amplifying, filtering and/or evaluating the signal provided by the active element.

"Single photon detection" may refer to a process suitable and/or configured for detecting one single photon. In other words, the absorption of one single photon may be sufficient for resulting in a detectable signal provided by the active element.

The graphene layer stack may refer to a stack of multiple graphene layers stacked on top of each other. The graphene layers may be stacked directly on top of each other, i.e. without providing different materials and/or elements between the stacked graphene layers. The graphene layers may be regarded as "directly stacked" in such cases, in which optionally unavoidable contaminations may be present between adjacent graphene layers stacked on top of each other. The graphene layer stack may form a "magic-angle twisted bilayer graphene", also known in prior art by the abbreviation "MATBG". The graphene layers of the graphene layer stack may be arranged in a flat and/or plane manner, i.e. each of the graphene layers may extend in a flat plane and may not be curved. However, according to other embodiments the graphene layer stack may be curved, wherein all graphene layers of the graphene layer stack may extend in a parallel fashion having the same curvature.

The "global twist angle" may relate to an angle, by which graphene layers stacked on top of each other differ in the orientation with respect to each other. The global twist angle may relate to an angle by which the crystal lattices are twisted with respect to each other in a projection plane being parallel to the planes of the respective graphene layers. The stacked graphene layers may be arranged in a parallel manner, i.e. that the crystal lattices of the graphene layers extend in planes being parallel to each other. The global twist angle may be an average angle by which the crystal lattice structures of the individual graphene layers are twisted against each other in the active area. The graphene layers being twisted against each other may be understood as the graphene layers being arranged relative to each other such that the planes of their graphene crystal lattices extend in a parallel manner with respect to each other, wherein the orientation angles of the graphene crystal lattices of the different graphene layers differ from each other, optionally in average, by the global twist angle. The graphene layers may exhibit local deviations from the global twist angle throughout the active area, as specified in this description. The global twist angle being in a range from 0,90° to 1,25° means that the global twist angle of the graphene layer stack has a constant value in the active area falling in the given angular range from 0,90° to 1,25°. The global twist angle being in a range from 0,90° to 1,25° does not mean that local deviations from the global twist angle are allowed to fill the entire angular range from 0,90° to 1,25°. For example, according to a first exemplary embodiment the global twist angle may be 1,00° in the entire active area, according to a second exemplary embodiment the global twist angle may be 1,04° in the entire active area, and according to a third exemplary embodiment the global twist angle may be 1,10° in the entire active area. All these exemplary embodiments satisfy the condition of having a global twist angle in the range of 0,90° to 1,25°, while none of these examples exhibit a variation of the local twist angle filling in the entire angular range of the allowed global twist angles.

The graphene layer stack may be provided such that the graphene layers are stacked in a manner that there are no local deviations from the global twist angle throughout the entire active area. Moreover, the graphene layer stack may be provided such that the graphene layers are stacked in a manner that there are local deviations from the global twist angle. In this case, the local deviations from the global twist have to be such that a standard deviation of the local deviations from the global twist angle is 0.04° or less in the entire active area. The standard deviation relates to the square root of the variance of the deviations from the global twist angles of all deviations within the active area. The standard deviation of the local deviations from the global twist angle in the active area may be determined based on the local deviations along one cross-sectional cut through the active area, which may be regarded as being representative for all local deviations in the active area.

The global twist angle and the local deviations may be determined based on measurements using a nanoscale on-tip scanning superconducting quantum interference device (SQUID-on-tip). The measurement may be carried out along one cross-sectional cut through the active area, which may be regarded as being representative for all local deviations in the active area. The measurement may be carried with a SQUID-on-tip technique as described in the publication indicated below using the exact protocol and measurement details as described in the publication indicated below, as well as the related supplementary information and references cited in said publication. The publication may be retrievable at: https://doi.org/10.1038/s41586-020-2255-3
*A.* Uri et al.: Mapping the twist-angle disorder and Landau levels in magic-angle graphene, Nature, Vol. 581, 7 May 2020, pages 47 to 52
including the "Methods" section, all supplemental information and references cited with regard to the measurement technique.

The used parameters and settings are chosen as provided in the methods section of the publication mentioned above, specifically in the sections *"Technique for direct imaging of the current and evaluation of the current in the incompressible strips", "Determination of twist-angle measurement accuracy and spatial resolution"* and *"Landau level tomography and twist-angle mapping".* Besides, For the used measurement devices, the standard settings shall be used for carrying out the measurements, unless specified otherwise.

"Applying a gate voltage to the active area such that an electrostatic doping level of the active area is in a range between half-filling and the three-quarter filling of a Moiré unit cell, -3 < *v* < -2 and optionally is v=-2.45, " may relate to providing a charge carrier density in a range between n=-1,8 × 10¹²cm⁻² and n=-1,4 × 10¹²cm⁻² and optionally at n=-1,56 × 1012cm-2 in the active area. Negative carrier density values may indicate hole doping in the MATBG, while positive carrier density values may indicate electron doping. The gate voltage may be applied at a gate electrode arranged underneath the active area. The negative values of the charge carrier density indicate a "hole doping", i.e., that the active area is doped with positive electron holes.

Indicated directions, such as "on top", "underneath" etc. are to be understood in a purely relative manner with respect to the active element, the active area and/or the single photon detector. The absolute orientations and positions may change when the position and/or orientation of the active element and/or the single photon detector changes.

The resistivity of the active area may be a property of the active area which is independent of the spatial dimensions of the active area. Since the active area is to be regarded as a two-dimensional device, the unit of the resistivity is provided in Ω instead of Ω · m as used for three-dimensional materials.

The disclosure provides the advantage that the active element may be operated such that the absorption of a single photon may result in a complete breaking of the superconductivity of the active area, i.e., that the absorption of a single photon may result in a transition of the entire active area from a superconductive state into a normal conductive state. This may allow for the generation of a significantly higher voltage signal upon absorption of a single photon as compared to conventional TES SPDs and, thus, may allow a significantly higher sensitivity and/or a sensitivity for photons in spectral ranges not accessible for conventional SPDs, such as the infrared and in particular Terahertz spectral range having photon energies of about 1 meV.

Moreover, the disclosure provides the advantage that the active element may exhibit a hysteretic behavior of the measured probe voltage with respect to a sweeping direction of a bias current through the active area which may be characterized by Δ*I* = *I_{c}* - *Iᵣ*, where *I_{c}* is a switching current at which the active area switches into the normal conductive regime and *Iᵣ* is a retrapping current, at which the active area switches back into the superconductive regime. The hysteresis may extend over a range of bias currents of about 5 nA to about 50 nA and optionally of about 10 nA to about 20 nA.

The hysteresis may arise from a current-induced self-heating hotspot forming when the active area is in the normal conductive state. The presence of this state may be beneficial for significantly enhancing the sensitivity for single-photon detection. When a single photon is absorbed in the active area, it may generate a resistive domain of quasi particles which may disturb the superconductive equilibrium state. If the active area is biased within the hysteresis loop, this resistive region may expand due to the self-sustained Joule heating, which may lead to a complete switching of the entire active area into the normal conductive state across the entire active area which may be in the range of 10 µm² to about 20 µm². This way the absorbed single photon may generate a probe voltage output equivalent to the regular voltage in the normal state at the given bias, which may be *Vₚₕ* = *V*(*I_{bias}*) ≈ 0,5*mV.*

Consequently, the disclosure provides the advantage that a significant change of electrical resistance can be achieved by the absorption of a single photon, which may be significantly higher than a change of electrical resistance achievable in conventional SPDs.

Moreover, the disclosure may provide the advantage that a well-defined transition of the active area from the superconductive state to the normal conductive state of the entire active area may be exploited for single photon detection, which may enhance the signal-to-noise ratio of the SPD.

The at least two graphene layers may be stacked on top of each other such that a maximum local deviation from the global twist angle in the active area is ±0,2° or less. In other words, the allowable range of local deviations from the global twist angle in the active area may be restricted to ±0,2°. This is not in conflict with the requirement that the standard deviation of local deviations from the global twist angle in the active area is 0,04° or less. The restriction of the local deviations may result in a graphene layer stack and, thus, a MATBG structure, having a very high homogeneity. This may enable or facilitate a transition of the entire active area from the superconductive state into the normal conductive state upon absorption of one single photon. Moreover, this may enable or facilitate the hysteretic behavior of the *I*-*V* characteristics of the probe voltage over the bias current, as explained above.

The active element may further comprise an encapsulation of the graphene layer stack. The encapsulation may provide the advantage that the stability of the active element and/or the active area may be improved. Moreover, this may provide the advantage that the high homogeneity of the active area with regard to the twist angle can be conserved or its conservation may be facilitated.

The encapsulation of the graphene layer stacks may comprise or consist of hexagonal boron nitride, hBN. The encapsulation may comprise a first hBN layer arranged underneath the graphene layer stack and a second hBN layer arranged on top of the graphene layer stack. This may provide a sandwiched arrangement of the graphene layer stack and, thus, of the active area between the hBN layers thus mechanically protecting the active area. Each of the hBN layers may have a thickness in a range from 2 nm to 20 nm and optionally in a range from 5 nm to 10 nm. The encapsulation may shield the graphene layer stack from chemicals and/or air during the fabrication process and may also enhances the charge carrier mobility of graphene the graphene layer stack as compared to graphene layer stacks without encapsulation, which may be arranged directly on bare SiO₂ substrates.

The active element may further comprise a gate electrode arranged underneath the active area of the encapsulated graphene layer stack for electrostatic tuning of a carrier concentration on the graphene layer stack. This may allow adjusting a charge carrier density in the active area to a suitable level for single photon detection. In particular, the charge carrier density in the active area may be adjusted to be in a range from -1,8 × 10¹²cm⁻² to -1,4 × 10¹²cm⁻². Negative carrier density values may indicate hole doping in the MATBG, while positive carrier density values may indicate electron doping.

The gate electrode may be made of graphite. Graphite may exhibit a metallic behavior. The gate electrode may have a thickness of 5 nm or less and optionally of 2 nm or less. This may allow providing the gate electrode with suitable electrical properties for serving as a gate electrode while exhibiting a sufficient optical transparency. Moreover, limiting the thickness of the gate electrode to said range may provide the advantage that absorption of electromagnetic radiation can be kept low and by this a global heating of the active area in the superconductive state may be kept low.

The active element may be arranged on a silicon substrate. Moreover, the active element may be arranged on an insulator-on-silicon substrate, such as a 285nm-silicon dioxide/silicon substrate. This may allow integrating the active element into silicon based microelectronic chips.

The active area may have a spatial extension in a range from 5 µm² to 50 µm². The spatial extension relates to a spatial extension perpendicular to the thickness of the graphene layer stack, i.e. an extension parallel to the plane in which the crystal lattice of the respective graphene layers extends. Alternatively or additionally, the active area may have a width in a range from 3 µm to 7 µm. The width of the active area may be defined by probe contacts arranged at the active area. The specified spatial extension of the active area and/or the specified width of the active area may enhance or facilitate the formation of a superconductive channel through the active area.

The active element may further comprise a source contact for applying a bias voltage to the active area and/or one or more probe contacts for probing a change of electrical resistance of the active area. The source contact may be arranged such that the bias voltage may be applied in a longitudinal direction of a superconductive channel formed in the active area, i.e. in a direction perpendicular to the width of the active area and the thickness of the graphene layer stack. The probe contacts may be arranged at the longitudinal ends of the superconductive channel, i.e. in a longitudinal direction of the active area. These features may allow contacting the active element in order to measure a voltage signal generated by absorbing a single photon in the active area.

The single photon detector may further comprise a cooling device for cooling at least the active area of the graphene layer stack to a temperature below 3 K, optionally below 2 K, optionally below 1 K, optionally below 700 mK and optionally below 100 mK. Optionally, the single photon detector may comprise a cooling device for cooling the active area to a temperature of 50 mK or less and optional to 35 mK or less. The cooling device may comprise a dilution refrigerator.

The single photon detector may further comprise an RC low-pass filter and/or an RF filter for rejecting high frequency noise from the active area. This may ensure proper cooling of the electrons in the active area and formation of the supercondcuting state.

The single photon detector may further comprise a voltage generator and a voltage divider being connectable or connected in series to a source contact of the active element.

The single photon detector may further comprise a low-noise amplifier being connectable or connected to one or more probe contacts of the active area and being configured to detect an electrical voltage and/or an electrical potential at the one or more probe contacts.

The single photon detector may further comprise a low-pass filter for limiting a read-out bandwidth to be read out by the low-noise amplifier.

The single photon detector may further comprise a sampling oscilloscope and/or an analog-to-digital converter for receiving a signal amplified by the low-noise amplifier.

In the method for detecting a single photon, the change in resistivity upon absorption of a photon may be in a range from 5 kΩ to 40 kΩ and optionally from 10 kΩ to 20 kΩ. Assuming the active area with a width of 5 µm and a length of 3 µm and a resulting change in resistivity of the active area of 17 kΩ, the resulting change of resistance of the active area would be 10 kΩ when switching from the superconductive state to the normal conductive state.

The disclosure presented above may be summarized as follows, without being limited to the following description:
The disclosure may outline a novel approach for SPD employing MATBG and other graphene-based superconductors. The inventors may have performed a proof-of-principle experiment to demonstrate the capability of detecting single-photons with MATBG.

The disclosed mechanism used for SPD is described below for one or more optional embodiments. Further optional embodiments including the detailed description of the experiment and the sample fabrication are also embraced by the present disclosure.

A brief review of prior art on superconducting single-photon detectors is provided. Transition-edge sensor (TES) detectors involve a temperature increase due to absorbed photon energy, locally interrupting the superconducting state and causing a sensitive resistive change measured with superconducting quantum interference device (SQUID) probes. Another alternative is represented by superconducting nanowires single-photon detectors (SNSPDs), consisting of nanostructured superconducting strips cooled down well below their critical temperature and operating at a bias current slightly smaller than the critical current [3].
[3] Morozov, D. V. et al. Superconducting photon detectors. Contemporary Physics 62, 69-91 (2021).

Photon absorption may generate quasi particles which may be confined in the small width of the strip, rapidly destroying superconductivity and generating a short-lived resistive region, resulting in a measurable voltage output.

The detection mechanism according to the disclosure may deviate from the previous technologies. Unlike TES, which involve partial breaking of the superconducting state and sensitive SQUID readout, the device proposed in this disclosure may induce a complete transition of the entire device from the superconducting to normal state, wherein the active area may have a size of about 15 µm². This mechanism may also differ from SNSPDs, where the short-lived resistive region is generated by constriction of the hotspot within the thin (~ 100 nm) superconducting strip. Notably, the MATBG device according to the disclosure may eliminate the need for any nanopatterning or nanostructure, and there is no confinement of the photo-induced quasiparticles in a nano-strip.

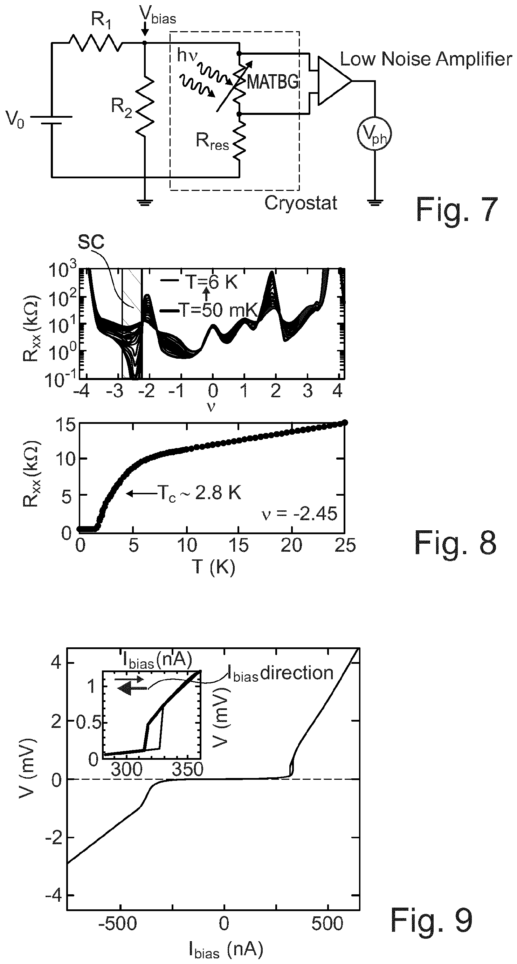

The differentiating factor may lie in the fact that the MATBG device fabricated according to the disclosure may have an intrinsic current-induced self-heating hotspot which manifests as a hysteresis loop in the *I*-*V* characteristic (see also Figure 9 below). The presence of this state may enable the complete breaking of superconductivity upon absorption of single-photons.

In the following section, we provide detailed descriptions of optional features of the present disclosure, focusing on implementations of a superconducting SPD based on MATBG.

The MATBG device may comprises two graphene sheets with a global twist angle (*θ*) of 1.04°±0.02, encapsulated within insulating hexagonal boron nitride (hBN) layers. An underlying metallic graphite gate may allow for the electrostatic tuning of carrier concentration through external gate voltage application.

At electrostatic doping levels between half-filling and the three-quarter filling of the Moiré unit cell, and optionally to v=-2.45, the produced device may show a pronounced superconducting dome with a normal state resistance of about 10 kΩ and critical temperature of *T_{c}* ~ 2,8 K, calculated as 50% of its normal state resistance (see also Figure 8 below).

### The active element may have the following features:

The active element may exhibit the presence of a hysteresis loop in the *I*-*V* characteristic of the superconducting state. We measure the MATBG device in a 4-terminal current-biased scheme at *T* = 35 mK. The fabricated device may show a clear hysteretic behavior with respect to the sweeping direction of the bias current, characterized by *ΔI* = *I_{c}* - *Iᵣ ~* 15 nA, where *I_{c}* and *Iᵣ* are the switching and retrapping current respectively (see also Figure 9 below). Such feature may arise from a current-induced self-heating hotspot when the MATBG is in the normal state. The presence of this state may enable single-photon detection in our investigation. Indeed, when the photon is absorbed, it may generate a resistive domain of quasiparticles which disturbs the superconducting equilibrium state. If the detector is biased within the hysteresis loop, this resistive region may expand thanks to the self-sustained Joule heating, leading to the complete switching of the detector into the normal state across the entire ~ 15 µm² active area. In this way the absorbed photon may produce a voltage output equivalent to the voltage in the normal state at the given bias: *Vₚₕ* = *V*(*I_{bias}*) ~ 0.5 mV.

A large change in resistance of about 10 kΩ may occur when the active area undergoes a transition from the superconducting to the normal conductive state. Since in graphene-based materials the electric contacts may be made through a one-dimensional contact which may have a typical resistance of tens of kΩ, a large change in resistance upon photon absorption may be beneficial to make the resistance increase measurable and the SPD event detectable.

The *I*-*V* curve may remain flat and in particular as flat as possible for currents *I* < *I_{c}* and may abruptly switch to the normal conductive state when *I* > *I_{c}* leading to a complete latching of the detector in the normal state. This may benefit from a large superconducting region that uniformly transitions to the normal state at the same critical current. Potential local disorder within the heterostructure may induce pronounced non-linear behavior near *I_{c}*, adversely affecting detector performance.

Achieving a well-defined transition is beneficial for the optimal functioning of the detector.

The critical current may be in the order of hundreds of nanoamperes. This is because the self-induced Joule heating, which may be responsible for the observed hysteresis loop, is given by the formula *P_{J}*=*I²R.* Achieving a combination of both a relatively high critical current and a large normal state resistance may be beneficial to generate the required self-heating effect, contributing to the distinctive hysteresis loop observed in our device.

Based on these considerations, these characteristics may be beneficail for an optimal performance of the active element. The attainment of these features may be facilitated by advancements and optimization in the fabrication of such two-dimensional heterostructures as well as technical improvements in the measurement setup.

The active element may be fabricated using a "cut-and-stack" technique. A stamp optionally made of propylene carbonate (PC) and polymethyl siloxane (PDMS) may be prepared and mounted on a glass slide. The stamp may be used to pick up the top layer of hexagonal boron nitride (hBN). The hBN layer may then be used to pick up the two halves of graphene, which may be pre-cut using an atomic force microscopy (AFM) tip. The graphene halves may be carefully rotated to a target twist angle of about 1.1°. To complete the graphene layer stack, the entire stack may be fully encapsulated with a bottom hBN layer. A graphite layer may be added at the bottom of the stack, serving as a local back-gate for the active element. The full stack may then be deposited onto a Si/SiO₂ chip and etched into a Hall bar geometry. Finally, edge contacts made of Cr/Au (5/50 nm) may be evaporated onto the device to establish electrical connections.

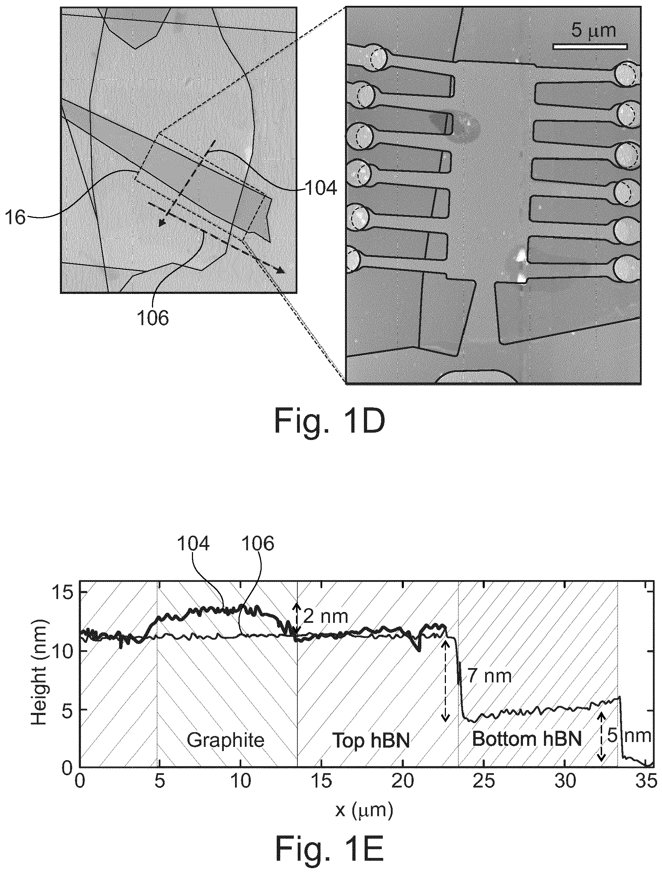

The inventors believe that there may be beneficial technical advancements for producing high-quality active elements devices for SPD:
a. Twisted moiré materials may inherently exhibit an unconventional type of disorder due to local variations in the twist angle within the same sample, as disclosed in [4].
   [4] Uri, A. et al. Mapping the twist-angle disorder and Landau levels in magic-angle graphene. Nature 581, 47-52 (2020). This disorder may be primarily caused by stacking faults or structural defects, and may significantly impact the transport properties of MATBG. Therefore, it may be benefical to control this parameter through a careful and smooth stacking procedure to reduce strain and prevent the formation of bubbles. An exemplary optical image of a typical stack is shown in Figure 1D. Notably, the fabrication process may selectively utilize the central region of the graphene layer stack. This central region may be chosen due to an often high homogeneity, as supported by the accompanying AFM image. An ultra-clean and homogeneous nature of the stack in the most homogeneous region, may ensure the optimization of MATBG device quality.
b. Based on our experience, mechanical strain may mostly accumulate in the final step of the stacking process while picking up the graphite gate. Complete encapsulation of the graphite gate with the bottom hBN flakes may facilitate the pickup from the substrate mitigating strain.
c. For successful SPD it may be benefical to use graphite gates with thicknesses of a few nm (~ 2 nm or less). A gate with greater thickness could absorb considerably more electromagnetic radiation, inducing global heating of the MATBG SC state.
d. The graphite gate may be placed at the bottom of the stack and serve as a back gate. Using graphite as a top gate may prevent some light from efficiently coming through and being absorbed by MATBG.
e. The hBN flakes employed for encapsulating the MATBG layer may have a thickness ranging from 5 to 10 nm. A minimum thickness of approximately 5 nm may be beneficial to thermally isolate the MATBG superconductor from the graphite gate, which may experience heating upon photon absorption. Additionally, it is essential to ensure that the hBN thickness does not exceed 10 nm, as this allows for optical transparency. This optical transparency may facilitate the visualization of the MATBG underneath using an optical microscope, aiding in the identification of any cracks or folds in the graphene layers that must be avoided during the fabrication process.
f. The width of the fabricated device may be considered. The width of the channel may be chosen to be between 3 µm and 7 µm. As discussed in point a, an inherent disorder in twisted moiré materials, caused by local variations in the twist angle, may make achieving a uniform SC region challenging. Despite the twist angle inhomogeneity, the fabricated device width may be strategically chosen to maximize the probability of obtaining a SC channel within the device.

The inventors also describe an experimental setup which may be used for SPD. To perform the photoresponse measurements we placed the device on the cold finger of a dilution refrigerator, housed in a gold-coated oxygen-free copper box. The dilution refrigerator (base temperature of 35 mK) was optimized for low-frequency transport of low-carrier density two-dimensional superconducting materials. A two-stage RC low-pass filter was mounted at the 1-K still plate of the dilution refrigerator combined with an additional RF filter mounted at the mixing chamber stage to ensure millikelvin electron temperature and reject high frequency noise. The overall bandwidth of the readout was < 1 kHz. Due to the ultra-low carrier density of the MATBG superconductor, maintaining a low electronic temperature and minimizing potential ground loops may be beneficial factors for observing the hysteresis loop in the *I*-*V* characteristics and achieving a sharp SC transition. In the SPD experiment described, the bias voltage may be applied at the source contact with a voltage generator in series with a 1/1000 voltage divider (*R₁* = 1MΩ, *R₂* = 1kΩ). The voltage probes may be connected to a room-temperature 1-MHz-bandwidth low-noise amplifier. A room-temperature low-pass filter with a sharp cut-off at ~ 1-10 kHz may be used to cancel out white noise outside of the readout bandwidth. The amplified signal may be fed to a sampling oscilloscope or an analog-to-digital converter. The optical excitation may be provided by a 1550 nm laser diode. The light may be fed into the dilution refrigerator to the MATBG detector, through a single-mode optical fiber coupled with a collimator mounted a few centimeters over the top of the sample space, allowing illumination of the entire device area at a spot-diameter of ~ 4 mm. To control the incident laser power, a programmable optical attenuator was employed, enabling precise adjustment over several orders of magnitude.

The inventors have performed an experiment to demonstrate the feasibility of detecting single photons with MATBG. Here the inventors describe the optional experiment and the results obtained. We bias our active element near the normal-superconductor transition. When a photon is absorbed, it may break Cooper pairs and produce a voltage output. In order to prevent the detector to "latch" permanently in a stable resistive state, i.e. to prevent the detector from permanently remaining in the resistive state, where it no longer detects photons, we may implement a self-reset circuitry, which may be regarded as an auto-reset circuitry. The circuit is constituted by a voltage divider with a load resistor *R₂* << *Rᵣₑₛ* + *R_{MATBG}.* Here *Rᵣₑₛ* is a residual resistance (which may arise from the contact resistance and the metallic leads) and R_{MATBG} is the 4-terminal resistance of the device active region, sketched as a variable resistor. The voltage bias scheme may maintain a constant voltage across the source and drain contacts of the device (*V_{bias}*)*.* In this way, the increase of resistance induced by the switching of the MATBG detector in the normal state, may divert part of the current into the load resistor *R₂* reducing the current flowing into the detector and consequently the Joule heating, analogously to an electrothermal feedback. Once the current is reduced, the detector may return to the superconducting state. The voltage probes in the 4-terminal scheme may be connected to a room-temperature low-noise amplifier, the output of which may be fed to an oscilloscope or an analog-to-digital converter to measure the voltage over time induced by the photons. When the active element transitions into the resistive state upon photon absorption, we register a spike in *V*ₚₕ, the detector then resets itself, and we can then measure the statistics of counts as a function of bias voltage, laser power and temperature.

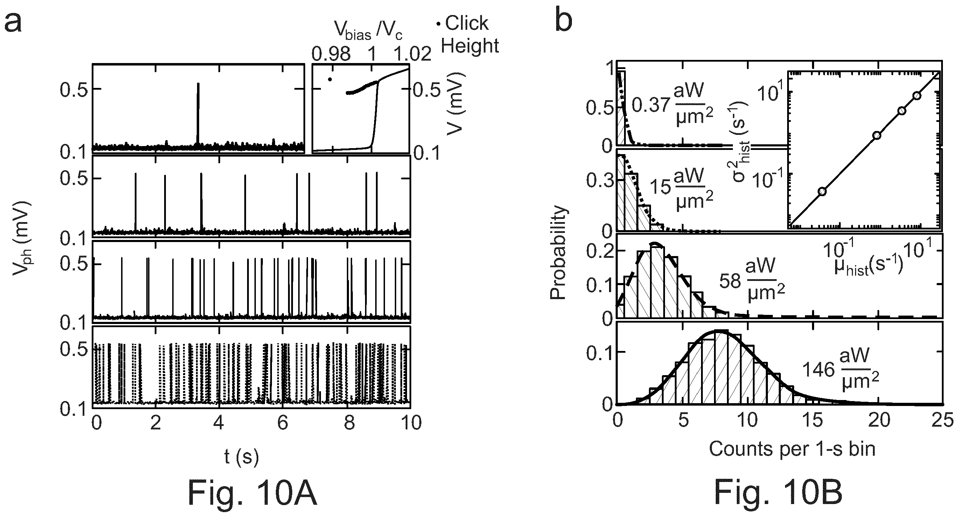

We measure the photovoltage traces *V*ₚₕ(*t*) over time across the MATBG detector when it is exposed to the laser beam radiation in the configuration described above with reference to Figure 7. We observe voltage spikes emerging as we increase the incident laser power (see also Figures 10A and 10B below). These 'clicks', i.e., detected probe signals, of our detector are photo-induced switching events from the superconducting to the normal state. We investigate their stochastic nature by producing histograms of counts with 1-s bins and extracting the mean (*µₕᵢₛₜ*) and variance (*σ²ₕᵢₛₜ*) of the sampling distribution. For all the histograms the mean equals the variance, as described by a Poisson process. We further demonstrate the agreement with this statistic by plotting the Poisson distribution on top of the histograms with the extracted µ*ₕᵢₛt* and *σ²ₕᵢₛₜ.* The excellent agreement between the experimentally registered counts and the statistical model confirms that our observation is indeed compatible with the photon shot noise generated by the highly attenuated CW laser source.

Additionally, we examine the average click height, i.e. signal amplitude, as a function of the bias voltage, *V_{bias}* (see also Figure 10A below). We find that the generated photovoltage closely matches the voltage in the normal state across all explored bias voltages: *V*ₚₕ(*V_{bias}*) ≈ *V*(*V_{bias}*)*.* This observation indicates that the incident photons induce a complete transition of the MATBG detector from its superconducting state to the normal state.

To investigate the photoresponse, we compare the photon count rate PCR (counts recorded per second) for different bias voltages without light and with an excitation wavelength of *λ* = 1550 nm for different laser powers. When the detector operates at a bias voltage far from the transition, the PCR is orders of magnitude higher upon illumination than in the dark, while as *V_{bias}* approaches *V_{c}* a sudden increase in false-positive (dark) counts occurs, ultimately dominating the detector's response. The experimental data exhibits a tendency to saturation at *V_{bias}* ~ 0.997 *V_{c}*. In SPDs, the saturation of the PCR as a function of current bias typically indicates that the internal detector efficiency, without coupling, may reach unity. Conversely in our experiment, the PCR curve does not entirely saturate, implying that the intrinsic efficiency attained may not be 100%.

To demonstrate single-photon sensitivity by the active element, we explore how the detector count rate evolves as a function of the CW laser power over several orders of magnitude at two different bias points. To provide a quantitative description of the light-induced count rate we estimate the power density incident on the active element (*P_{L}*) in the approximation of a gaussian beam. From *P_{L}* we can calibrate the number of incident photons per µm² in a time window *τ* as: 〈*Nₚₕₒₜₒₙ*〉 = *τ·P_{L}*/*hv,* where *hv* =1.28·10⁻¹⁹ J is the energy of a single photon at *λ* = 1550 nm. Choosing *τ* = 5 ms which is close to the typical detector recovery time, a laser power density of *P_{L}* = 10 aW/µm² corresponds to 〈*Nₚₕₒₜₒₙ*〉 = 0,4 photons incident per µm² in a time window of 5 ms. Under illumination with a weak coherent light source, the probability of detecting m photons in a detection time window reduces to ~ 〈*Nₚₕₒₜₒₙ*〉^{m}/m!*.* The measured detection probability increases linearly with 〈*Nₚₕₒₜₒₙ*〉 over > 3 orders of magnitude with an offset due to the dark counts, demonstrating single-photon sensitivity of the MATBG superconducting detector.

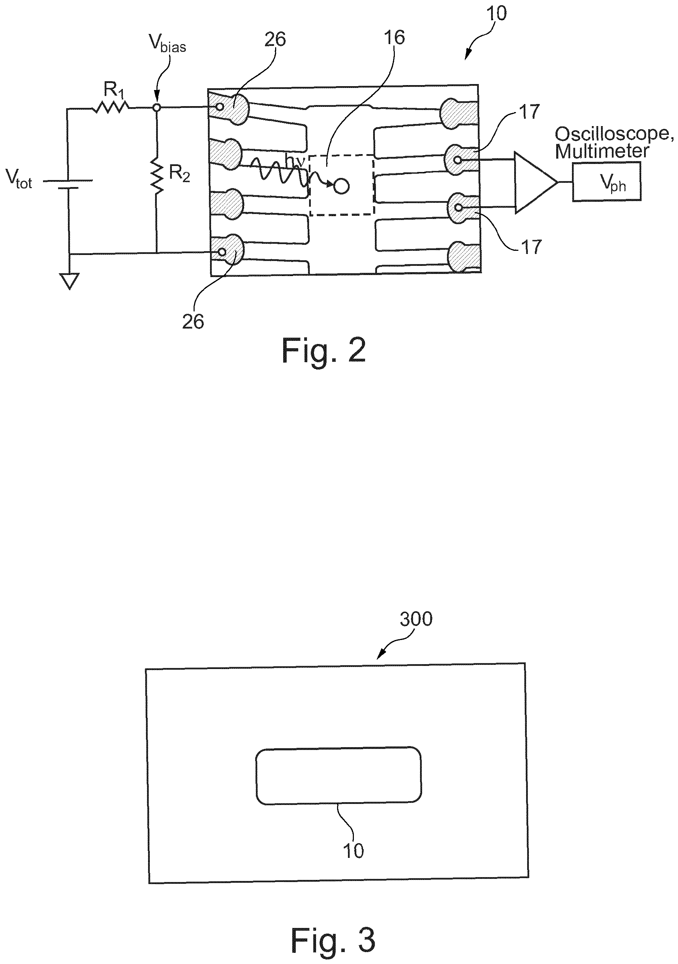

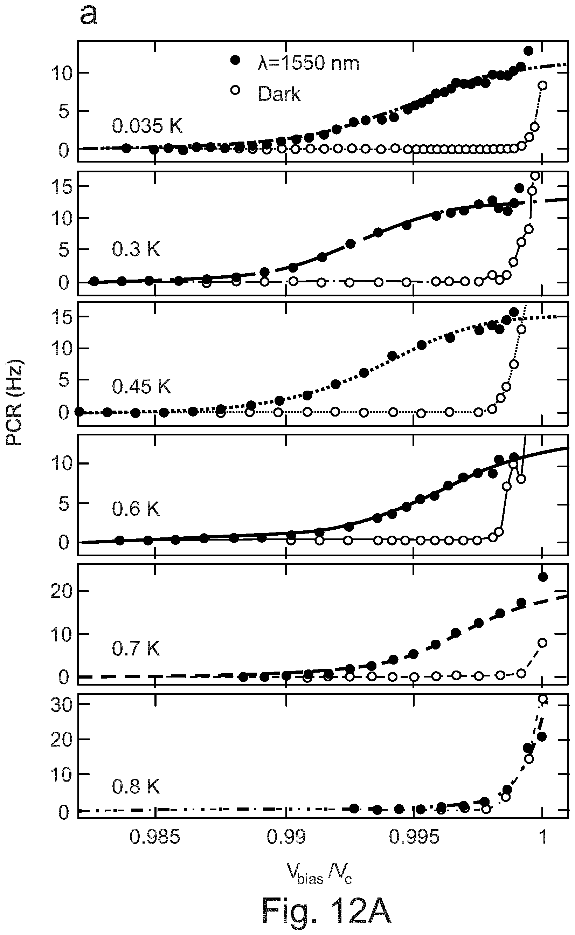

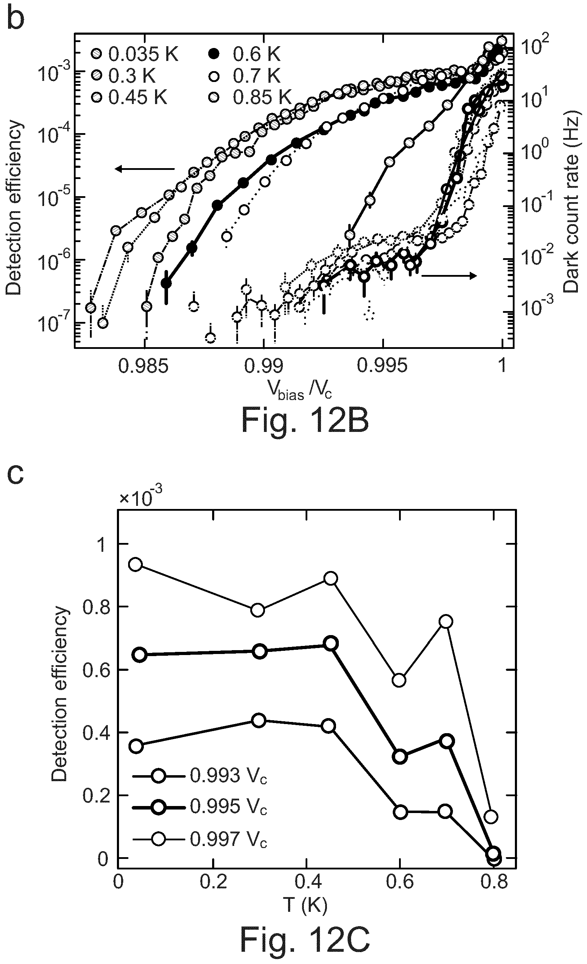

To provide further insights on the photodetection mechanism in MATBG, in Figure 12A we present the PCR versus *V_{bias}* at six different temperatures ranging from 35 mK to 800 mK, both with and without laser excitation (filled and empty dots, respectively). The PCRs with illumination are consistent with the sigmoid function and exhibit a tendency to saturation for *V_{bias}* ~ 0,997 *V_{c}* which confirm the SPD from our MATBG device up to ~ 0.7 K. The single-photon PCR eventually vanishes when the temperature rises up to 0,8 K, at which the dark count dominates the PCR. Figure 12B plots the SPD efficiency as a function of *V_{bias}* and the dark count rate (PCR without illumination) at various temperatures. Here the efficiency is defined as the ratio of counts detected per second to photons incident per second in the area (*A* ~ 16 µm²) between the two voltage probes (dashed box in the optical image of Figure 2). Interestingly, the dark count rate (right-hand-side of the y-axis) exhibits two distinct *V_{bias}* dependence above and below *V_{bias}* = 0,998 *V_{c}*. When *V_{bias}* > 0,998 V_{c}, a sharp increase in dark counts occurs. This justifies the abrupt rise of PCR under illumination when *V_{bias}* ~ *V_{c}*. When *V_{bias}* < 0.998 *V_{c}*, the dark counts rise gradually due to background photons coupling through the optical fiber connected at the room-temperature optical port. Notably, the detection efficiency on the lefthand-side of the y-axis is at the maximum and gradually decreases as the temperature rises, akin to observations in other SPDs.

To further investigate this trend, we extract the efficiency at three different *V_{bias}* from the sigmoid fit of Figure 12A, and plot them against the temperature in Figure 12C. The efficiency decreases as temperature rises. We attribute this to the increase of the thermal conductance. Elevated temperatures enhance heat transfer out of the electrons reducing the probability of latching into the resistive state by a self-heating effect. This argument is supported by thermal transport measurements in the superconducting state on the same system, which report a rapid increase in thermal conductivity within the range 35 mK < *T* < 800 mK.

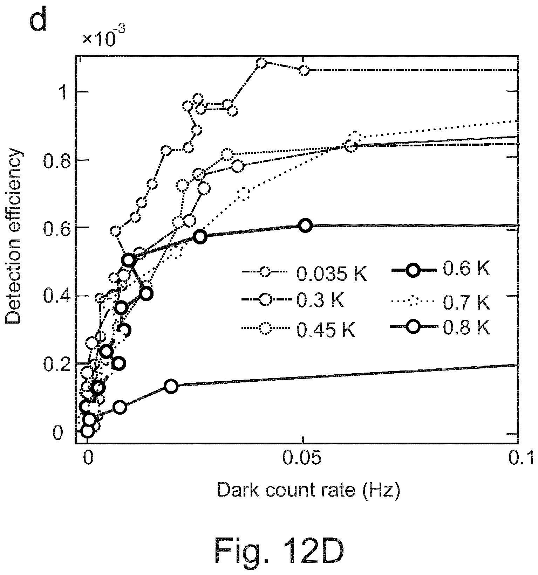

Figure 12D plots the trade-off between SPD efficiency and dark count rate at various temperatures to determine the optimal operating condition of our MATBG detector. We observe that the most favourable SPD performance may be achieved in the plateau region, where the efficiency approaches its maximum value while maintaining a low dark count rate.

It is understood by a person skilled in the art that the features described above and the features in the following description and figures are not only disclosed in the explicitly disclosed embodiments and combinations, but that other technically feasible combinations as well as the isolated features are comprised by the disclosure as well. In the following, several optional embodiments and specific examples are described with reference to the figures for illustrating the disclosure without limiting the disclosure to the described embodiments.

Optional embodiments of the disclosure will be illustrated in the following with reference to the drawings. The Figures show:
- Figures 1A to 1E: different aspects of active elements according to optional embodiments;
- Figure 2: an active element according to an optional embodiment and electrical circuitry;
- Figure 3: a single photon detector according to an optional embodiment;
- Figure 4: a single photon detector according to an optional embodiment;
- Figure 5: a method of detecting a single photon according to an optional embodiment;
- Figure 6: illustrates a method of manufacturing an active element for single photon detection according to an optional embodiment;
- Figures 7 - 12D: various aspects of an exemplary active element and single photon detector acording to optional embodiments; and
- Figures 13A and 13B: illustrations of the global twist angle and local deviations from the global twist angle.

In the drawings and the following description the same reference signs are used for corresponding or similar features in different drawings.

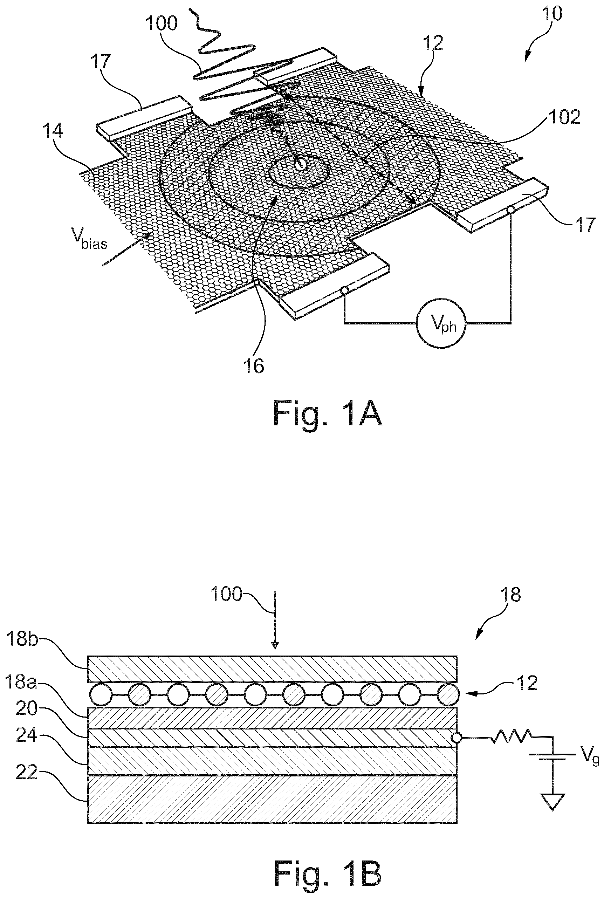

Figures 1A to 1E illustrate an active element 10 for single photon detection according to optional embodiments. Figure 1A illustrates a sketch of the active element 10 in a perspective view.

The active element 10 comprises a graphene layer stack 12 comprising at least two graphene layers 14 stacked on top of each other with a global twist angle forming an active area 16, wherein the global twist angle is in a range from 0,90° to 1,25°. The at least two graphene layers 14 are stacked on top of each other such that a standard deviation of local deviations from the global twist angle in the active area is 0,04° or less. The at least two graphene layers 14 may be stacked on top of each other such that a maximum local deviation from the global twist angle in the active area is ±0,2° or less.

The waveform or arrow 100 indicate an incident photon impinging on the active element 10.

The active area 16 may have a spatial extension in a range from 5 µm² to 50 µm². Alternatively or additionally, the active area 16 may have a width 200 in a range from 3 µm to 7 µm.

The active element 10 may further comprise a source contact for applying a bias voltage *V_{bias}* to the active area 16 and one or more probe contacts 17 for probing a change of electrical resistance of the active area 16.

According to the optional embodiment, the active area 16 may be formed by two layers of graphene 14 twisted by an angle of ~ 1.1° with respect to each other. The infrared photon 100, incident on the voltage-biased active element, may break Cooper pairs and generate a photovoltage output *V*ₚₕ.

Arrow 102 indicates the width of the active area 16.

Figure 1B illustrates a cross-sectional layout of the active element 10 in the active area 16 according to an optional embodiment. The active element 10 may comprise an encapsulation 18 of the graphene layer stack 12, wherein the encapsulation 18 of the graphene layer stacks 12 comprises or consists of hexagonal boron nitride hBN. The encapsulation 18 may comprise a first hBN layer 18a arranged underneath the graphene layer stack 12 and a second hBN layer 18b arranged on top of the graphene layer stack 12, wherein each of the hBN layers 18a, 18b may have a thickness in a range from 2 nm to 20 nm and optionally in a range from 5 nm to 10 nm.

The active element 10 may further comprise a gate electrode 20 arranged underneath the active area 16 of the encapsulated graphene layer stack 12 for electrostatic tuning of a carrier concentration on the graphene layer stack 12. The applied gate voltage is indicated as *V_{g}.* The gate electrode 20 is made of graphite and optionally has a thickness of 5 nm or less and optionally of 2 nm or less.

The active element 10 may be arranged on a silicon substrate 22, wherein the upper surface of the silicon substrate 22 may form an insulator layer 24, such as a SiO₂ layer.

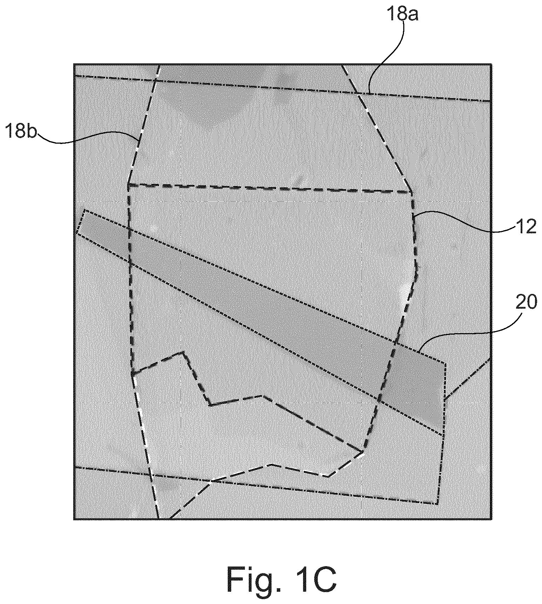

Figure 1C schematically illustrates a top optical view of the stacked layers of the active element 10 before nanofabrication, i.e. before providing electrical contacts to the active element. The stacked layers including from bottom to top the graphite gate 20, the first hBN layer 18a, the graphene layer stack 12, and the top hBN layer 18b.

Figure 1D schematically depicts an AFM image (right side) of the active element indicating the imaged section in the optical image of the stacked layers on the right side. The dashed square indicates the ultra-clean area used as active area 16 to fabricate the final active element 10. On the right side, Figure 1D depicts an AFM scan of the final device etched into a Hall bar geometry. The white scale bar is 5 µm.

Figure 1E shows the height profiles 104 and 106 taken from the AFM image along the respective dashed lines in Figure 1D from which the hBNs and graphite thicknesses can be extracted. As can be seen from the AFM measurement, the graphite gate electrode 20 may have a thickness of about 2 nm. The second hBN layer 18b and the graphene layer stack 12 of about 7 nm and the first hBN layer 18a of about 5 nm. The graph shows the transversal position of scan in micrometers on the horizontal axis and the height in nanometers on the vertical axis.

Figure 2 shows the optical image of the active element 10 according to an optional embodiment with additional illustrations of the electrical circuitry. An exemplary active area 16 measured by two probes voltage contacts 17 is marked by the dashed box and may have an area 108 of about 16 µm². The scale bar indicates a length of 3 µm. The voltage *V*ₚₕ at the probe voltage contacts may be read out for detecting the absorption of a single photon in the active area 16. The outer contacts 26 may be used to apply a bias voltage *V_{bias}* to the active area 16.

Figure 3 shows a single photon detector 300 comprising at least one active element 10 according to an optional embodiment.

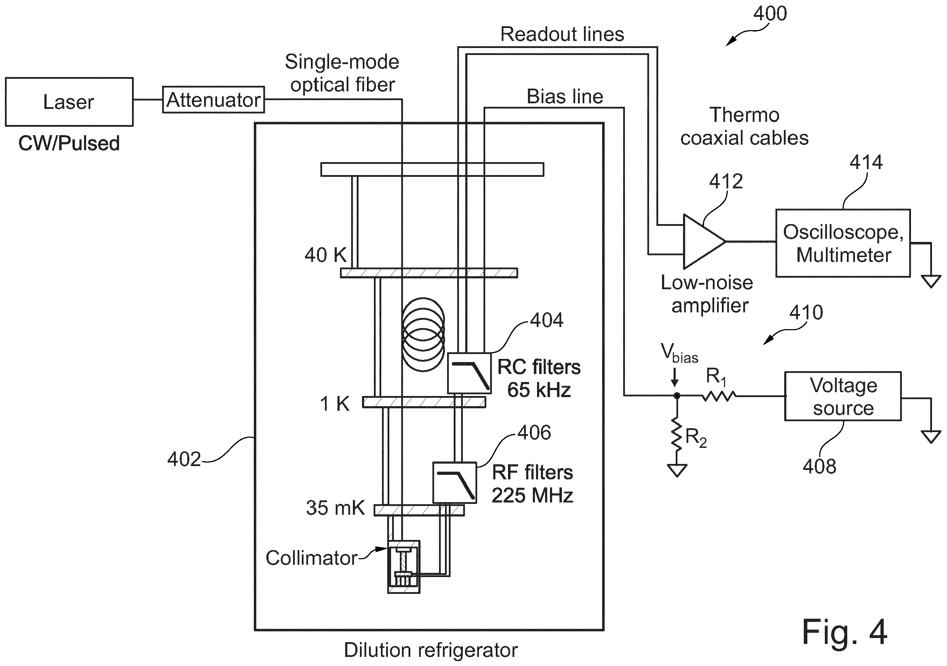

Figure 4 depicts a single photon detector 400 according to an optional embodiment. The single photon detector comprises a cooling device 402 for cooling at least the active area of the graphene layer stack to a temperature below 3 K, optionally below 2 K, optionally below 1 K, optionally below 700 mK, and optionally below 100 mK. The cooling device may provide areas of different temperatures, such as an area cooled to 40 K, and are cooled to 1 K and/or an area cooled to 35 mK. The cooling device may comprise or consist of a dilution refrigerator. Outside the cooling device the temperature may correspond to room temperature. The active element 10 may be arranged in the area cooled to 35 mK. The cooling device 402 may comprise or may be adapted as a dilution refrigerator.

The single photon detector 400 may further comprise an RC low-pass filter 404 and/or an RF filter 406, i.e. a radio frequency filter, for rejecting high frequency noise from the active area 10.

The single photon detector 400 may further comprise a voltage generator 408 and a voltage divider 410 being connectable or connected in series to a source contact of the active element 10.

The single photon detector 400 may further comprise a low-noise amplifier 412 being connectable or connected to one or more probe contacts 17 of the active area 16 and being configured to detect an electrical voltage and/or an electrical potential at the one or more probe contacts 17.

The single photon detector 400 may further comprise a low-pass filter for limiting a read-out bandwidth to be read out by the low-noise amplifier 412.

The single photon detector 400 may further comprise a sampling oscilloscope 414 and/or an analog-to-digital converter for receiving a signal amplified by the low-noise amplifier 412.

The photons to be detected by the single photon detector 400 may comprise a light source, such as a laser and one or more attenuators.

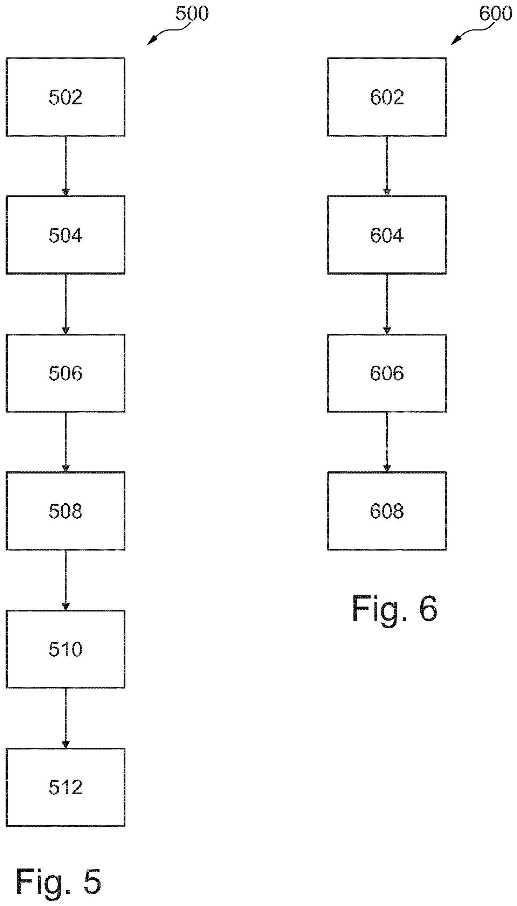

Figure 5 schematically illustrates a method 500 of detecting a single photon according to an optional embodiment.

In step 502 the method 500 comprises providing a single photon detector 300, 400 according to the disclosure.

In step 504 the method 500 comprises bringing the active area 16 of the single photon detector 300, 400 into a superconductive state.

In step 506 the method 500 comprises applying a gate voltage to the active area 16 such that an electrostatic doping level of the active area 16 corresponds to a filling factor of the Moiré unit cell of v=-2,45.

In step 508 the method 500 comprises applying a bias voltage across the active area (16) within a defined range from 95% to 100% of a switching voltage *V_{c}* and optionally 0,985 *V_{c}*, wherein the switching voltage *V_{c}* is a voltage, at which, when applied across the active area, the active area transitions from the superconductive state to a normal conductive state.

In step 510 the method 500 comprises measuring a probe voltage at the active area 16.

In step 512 the method 500 comprises determining an event in which the measured probe voltage exhibits a voltage change of 0.3 mV or more and/or a change in resistance of the active area of 10 kΩ or more corresponding to the entire active area 16 switching from the superconductive state into the normal conductive state as the absorption of a photon in the active area 16.

Figure 6 schematically illustrates a method 600 of manufacturing an active element 10 for single photon detection according to an optional embodiment.

In step 602 the method 600 comprises forming a graphene layer stack 12 including stacking at least two graphene layers 14 of the graphene layer stack on top of each other with a global twist angle, wherein the global twist angle is in a range from 0,90° to 1,25°.

In step 604 the method comprises selecting an area of the graphene layer stack 12 having a higher homogeneity than other areas of the graphene layer stack 12 as an active area 16 for the single photon detection, wherein the higher homogeneity corresponds to the at least two graphene layers 14 of the graphene layer stack 12 being stacked on top of each other such that a standard deviation of local deviations from the global twist angle in the active area is 0,04° or less.

In an optional step 606 the method 600 may comprise encapsulating at least the area of the graphene layer stack selected as active area 16.

In an optional step 608 the method 600 may further comprise arranging a gate electrode 20 underneath the active area 16 of the encapsulated graphene layer stack 12 such that the gate electrode 20 allows electrostatic tuning of a carrier concentration on the graphene layer stack 12.

In the following, further optional details and examples are provided without limiting the disclosure to these details and examples.

According to the optional embodiment, the active area may be formed by two layers of graphene twisted by an angle of ~ 1,1° with respect to each other. The infrared photon, incident on the voltage-biased active element, may break Cooper pairs and it generates a photovoltage output *V*ₚₕ.

Figure 7 shows a simplified circuit diagram which may be used to measure the photoresponse of the single poton detector. The voltage divider (*R*₁ = 1 MΩ, *R*₂ = 1kΩ) provides a voltage bias (*V_{bias}*) across the source and drain contacts of the active element including a MATBG. The incident photons may induce voltage spikes in the active element (sketched as a variable resistor) which are recorded using an oscilloscope or an analog-to-digital converter. *Rᵣₑₛ* ~ 53 kΩ is the residual resistance (arising from the contact resistance and the metallic leads).

Figure 8 depicts the four-terminal longitudinal resistance *Rₓₓ* of an active element according to Figure 1A having a global twist angle of the graphene layers of *θ* = 1,04°±0.02 as a function of the Moiré filling factor v (filling of electrons per Moiré unit cell) for temperatures ranging from *T* = 50 mK up to *T* = 6 K. At electrostatic doping levels corresponding to the half-filling of the Moiré unit cell (*v* = -2) we observe an insulating state flanked by a pronounced superconducting dome. The measurement of *Rₓₓ* vs. *T* at the optimal doping of *v* = -2.45 reveals a superconducting transition with a normal state resistance of about 10 kΩ and critical temperature *T_{c}* of about 2,8 K, calculated as 50% of its normal state resistance.

Figure 9 depicts superconducting *I*-*V* curves measured also at the optimal doping, displaying a hysteretic behavior with respect to the sweeping direction of the bias current, highlighted in the top inset.

Figure 10A shows raw photovoltage time traces, *V*ₚₕ *(t)* measured at increasing laser powers for *λ* = 1550 nm. Top right inset: Average click height measured as a function of *V_{bias}.* The click heights are overlaid on the *I-V* curve, measured in the configuration described in Figure 7.

Figure 10B shows histograms of counts in 1-s bins for the same laser powers in Figure 10A measured over ~ 10³ s time window. The inset shows that the extracted variance of counts *σ²ₕᵢₛₜ* is equal to its mean *µₕᵢₛₜ.* The agreement with the Poisson statistic is confirmed by plotting the Poisson distribution on top of the histograms with the extracted *µₕᵢₛₜ* and *σ²ₕᵢₛₜ* (solid lines).

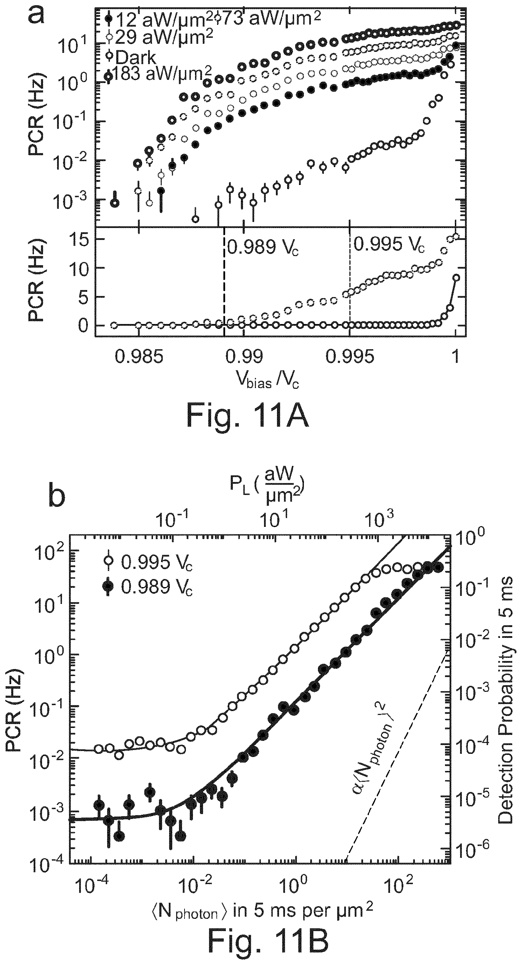

Figure 11A shows the photon count rate PCR as a function of voltage bias *V_{bias}* for four different laser powers (filled dots, higher PCRs for higher laser intensities) and in the dark (empty dots). Bottom panel: PCR vs. *V_{bias}* for *P_{L}* = 73 aW/µm² on a linear scale. The PCR shows a tendency to saturation at ~ 0.997 *V_{c}*. The vertical dashed lines are the bias points at which we performed the PCR vs. *P_{L}* measurements.

Figure 11B shows PCR versus the average incident photon number 〈*Nₚₕₒₜₒₙ*〉 in a 5-ms time window per µm² for two different bias points (upper curve: *V_{bias} =* 0.995 *V_{c}*; lower curve: *V_{bias} =* 0.989 *V_{c}*). On the top x-axis the corresponding incident CW power density *P_{L}* = 〈*Nₚₕₒₜₒₙ*〉·*hv*/*τ* is shown and on the right y-axis the corresponding detection probability in a 5-ms time window (PCR·*τ*). The solid lines are linear fits (with an offset due to dark counts), showing that the detection probability evolves linearly with 〈*Nₚₕₒₜₒₙ*〉 as prescribed for a SPD. The gray dashed line depicts a quadratic power dependence.

Figure 12A shows the photon count rate PCR as a function of voltage bias *V_{bias}* and temperature *T* upon illumination (filled dots) and in the dark (empty dots). The continuous lines are fit with the sigmoid function.

Figure 12B shows the detection efficiency vs. *V_{bias}* at different temperatures (filled markers) and the dark count rate vs. *V_{bias}* at different temperatures (empty markers). The detection efficiency is defined as the ratio of counts detected per second to photons incident per second in the area (A ~ 16 µm²) between the two voltage probes.

Figure 12C shows the detection efficiency vs. *T* for three different bias points extracted from the sigmoidal fit of Figure 12A.

Figure 12D illustrates a trade-off between detection efficiency and dark count rate for different temperatures.

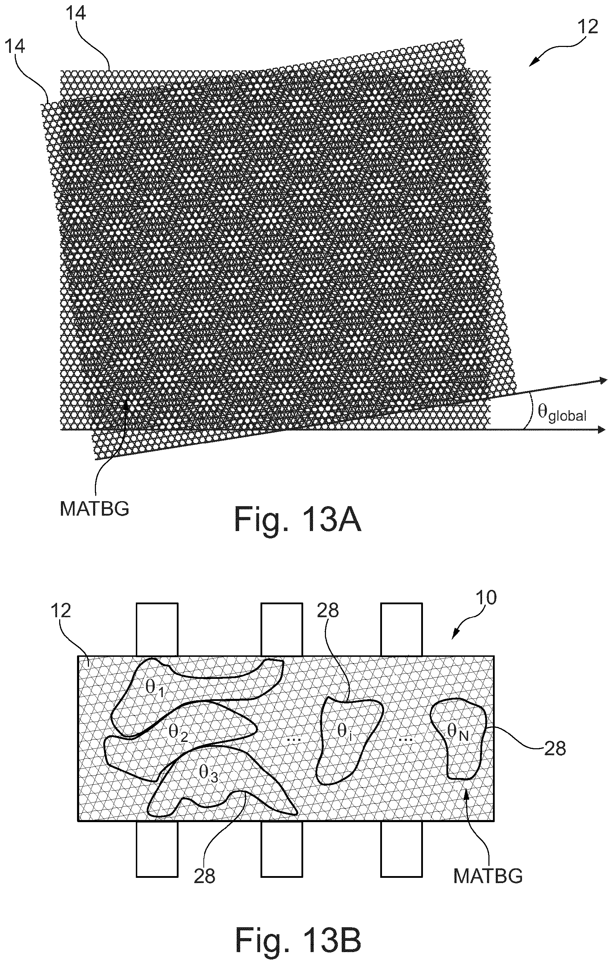

Figure 13A schematically illustrates the global twist angle *θ_{global}* between two graphene layers 14 of a graphene layer stack 14 stacked on top of each other. As can be seen, the graphene lattices of the graphene layers 13 are twisted in plane with respect to each other by the global twist angle *θ_{global}*, such that their graphene lattices do not overlap each other in a matching manner. The global twist angle *θ_{global}* may represent a macroscopic twist angle between the two graphene layers 14 of the graphene layer stack 12. For the sake of better illustration, global twist angle *θ_{global}* shown in Figure 13A may be presented in a strongly exaggerated manner.

Figure 13B schematically illustrates local deviations *θ*₁ to *θ_{N}* from the global twist angle *θ_{global}*, which the graphene layers 14 stacked on top of each ither may exhibit. The local deviations *θ*₁ to *θ_{N}* may arise from local variations of the twist angle, which may originate in the process of stacking the graphene layers 14 on top of each other. The local variations *θ*₁ to *θ_{N}* may be seen as a twist angle inhomogenetiy. Optionally, such local deviations *θ*₁ to *θ_{N}* may occur in confined areas 28. Optionally, the local deviations may originate in imperfections of the stackich process, such as by bubbles formed between the graphene layers. The local deviations *θ*₁ to *θ_{N}* may be reduced or minimized by ensuring a high quality of the the stacking process and, thus, by avoiding mechanical tensions between the graphene layers 14 and/or by avoiding bubbles between the stacked graphene layers 14. Reducing or minimizing the local deviations may be regarded as reducing or minimizing a standard deviation of the local deviations from the global twist angle throughout the active area. The standard deviation of the local variations (*θ*₁,..., *θ_{N}*) from the global twist angle may be a standard deviation calculated over all local deviations (*θ*₁,..., *θ_{N}*) present in the active area or in a representative subset of the local deviations (*θ*₁,..., *θ_{N}*) present in the active area.

### List of reference signs

- 10: active element
- 12: graphene layer stack
- 14: graphene layers
- 16: active area
- 17: probe contact
- 18: encapsulation
- 18a: first hBN layer
- 18b: second hBN layer
- 20: gate electrode
- 22: silicon substrate
- 24: insulator layer
- 26: outer contact(s)

- 100: incident light beam / incident photon
- 102: width of active area
- 104, 106: height profiles

- 300, 400: single photon detector
- 402: cooling device
- 404: RC low-pass filter
- 406: RF filter
- 408: voltage generator
- 410: voltage divider
- 412: low noise amplifier
- 414: sampling oscilloscope or analog-to-digital converter

- 500: method of detecting a single photon
- 502-512: method steps
- 600: method of manufacturing an active element for single photon detection
- 602-608: method steps
- *θ_{global}*: global twist angle
- *θ*₁ to *θ_{N}*: local deviations from global twist angle

## Claims

1. Active element (10) for single photon detection, the active element (10) comprising:
- a graphene layer stack (12) comprising at least two graphene layers (14) stacked on top of each other with a global twist angle (*θ_{global}*) forming an active area (16), wherein the global twist angle (*θ_{global}*) is in a range from 0,90° to 1,25°;
**characterized in that**
the at least two graphene layers (14) are stacked on top of each other such that a standard deviation of local deviations (*θ*₁,..., *θ_{N}*) from the global twist angle (*θ_{global}*) in the active area (16) is 0,04° or less.

2. Active element (10) according to claim 1, wherein the at least two graphene layers (14) are stacked on top of each other such that a maximum local deviation (*θ*₁,..., *θ_{N}*) from the global twist angle (*θ_{global}*) in the active area is ±0,2° or less.

3. Active element (10) according to claim 1 or 2, further comprising an encapsulation (18) of the graphene layer stack (12).

4. Active element (10) according to claim 3, wherein the encapsulation (18) of the graphene layer stack (12) comprises or consists of hexagonal boron nitride, hBN.

5. Active element (10) according to claim 4, wherein the encapsulation (18) comprises a first hBN (18a) layer arranged underneath the graphene layer stack (12) and a second hBN layer (18b) arranged on top of the graphene layer stack (12), wherein each of the hBN layers (18a, 18b) has a thickness in a range from 2 nm to 20 nm and optionally in a range from 5 nm to 10 nm.

6. Active element (10) according to any one of the claims 3 to 5, further comprising a gate electrode (20) arranged underneath the active area (16) of the encapsulated graphene layer stack (12) for electrostatic tuning of a carrier concentration on the graphene layer stack (12).

7. Active element (10) according to claim 6, wherein the gate electrode (20) is at least partially made of graphite and optionally has a thickness of 5 nm or less and optionally of 2 nm or less.

8. Active element at least according to any one of the claims 3 to 6, wherein the active element at least is arranged on a 285nm-SiO2/silicon substrate (22).

9. Active element (10) according to any one of the preceding claims, wherein
the active area (16) has a spatial extension in a range from 5 µm² to 50 µm²;
and/or
wherein the active area (16) has a width in a range from 3 µm to 7 µm.

10. Active element (10) according to any one of the preceding claims, further comprising:
- a source contact for applying a bias voltage to the active area (16); and
- one or more probe contacts (17) for probing a change of electrical resistance of the active area (16).

11. Single photon detector (300), **characterized in that** the single photon detector (300) comprises at least one active element (10) according to any one of the preceding claims.

12. Single photon detector (400) according to claim 11, further comprising one or more of the following components:
- a cooling device (402) for cooling at least the active area (16) of the graphene layer stack (12) to a temperature below 3 K, optionally below 2 K, optionally below 1 K, optionally below 700 mK, and optionally below 100 mK;
- an RC low-pass filter (404) and/or an RF filter (406) for rejecting high frequency noise from the active area (16);
- a voltage generator (408) and a voltage divider (410) being connectable or connected in series to a source contact of the active element (16);
- a low-noise amplifier (412) being connectable or connected to one or more probe contacts (17) of the active element (10) and being configured to detect an electrical voltage and/or an electrical potential at the one or more probe contacts (17);
- a low-pass filter for limiting a read-out bandwidth to be read out by the low-noise amplifier (412); and
- a sampling oscilloscope (414) and/or an analog-to-digital converter for receiving a signal amplified by the low-noise amplifier (412).

13. Single photon detector (400) according to claim 12, wherein the cooling device (402) comprises a dilution refrigerator.

14. Method (500) of detecting a single photon, the method (500) comprising:
- providing (502) a single photon detector (300, 400) according to any one of the claims 11 and 12;
- bringing (504) the active area (16) of the single photon detector (300, 400) into a superconductive state;
- applying (506) a gate voltage to the active area such that an electrostatic doping level of the active area (16) corresponds to a of a Moiré unit cell between -3 < v < -2;
- applying (508) a bias voltage across the active area (16) within a defined range from 95% to 100% of a switching voltage (*V_{c}*), wherein the switching voltage (*V_{c}*) is a voltage, at which when applied across the active area (16) the active area transitions from the superconductive state to a normal conductive state;
- measuring (510) a probe voltage at the active area (16);
- determining (512) an event in which the measured probe voltage exhibits a voltage change of 0,3 mV or more and/or a change in resistivity of the active area of 5 kΩ or more corresponding to the entire active area (16) switching from the superconductive state into the normal conductive state as the absorption of a photon in the active area (16).

15. Method (600) of manufacturing an active element (10) for single photon detection, the method (600) comprising:
- forming (602) a graphene layer stack (12) including stacking at least two graphene layers (14) of the graphene layer stack (12) on top of each other with a global twist angle (*θ_{global}*), wherein the global twist angle (*θ_{global}*) is in a range from 0,90° to 1,25°;
**characterized in that** the method (600) further comprises:
- selecting (604) an area of the graphene layer stack (12) having a higher homogeneity than other areas of the graphene layer stack (12) as an active area (16) for the single photon detection, wherein the higher homogeneity corresponds to the at least two graphene layers (14) of the graphene layer stack (12) being stacked on top of each other such that a standard deviation of local deviations (*θ*₁,..., *θ_{N}*) from the global twist angle (*θ_{global}*) in the active area is 0,04° or less.

16. Method (600) according to claim 15, further comprising:
- encapsulating (606) at least the area of the graphene layer stack (12) selected as active area (16); and
- arranging (608) a gate electrode (20) underneath the active area (16) of the encapsulated graphene layer stack (12) such that the gate electrode (20) allows electrostatic tuning of a carrier concentration on the graphene layer stack (12).
